# EUROPEAN PATENT APPLICATION

(11) **EP 4 848 284 A1**
(43) Date of publication of application: **02.12.2026**
(21) Application number: 26175898.1
(22) Date of filing: 30.04.2026
(51) Int. Cl.: G11C 5/14, G11C 11/16, G11C 11/22, G11C 13/00, G11C 16/30, G11C 17/18

(54) **POWER SUPPLY CIRCUIT AND CORRESPONDING METHOD FOR SUPPLYING POWER**

(30) Priority: 22.05.2025 IT 202500011683
(71) Applicant: STMicroelectronics International N.V., 1228 Plan-les-Ouates, Geneva (CH)
(72) Inventor: PERRONI, Maurizio Francesco, I-98054 Furnari (Messina) (IT); MANFRE', Davide, I-26025 Pandino (Cremona) (IT); CASTAGNA, Giuseppe, I-90135 Palermo (IT); CARUSO, Massimo, I-98122 Messina (IT)
(74) Representative: Buzzi, Notaro & Antonielli d'Oulx S.p.A.

(57) **Abstract**

A power supply circuit (10) configured to output, on the basis of a first high power supply voltage (V_{supply}) received at its input, power supply voltage values (Vₒᵤₜ) for transistors (50) operating with a second power supply voltage (V_{supply}') lower than said first high power supply voltage (V_{supply}), said power supply circuit (10) comprising a level shifter circuit (14; 24; 34) configured to supply said power supply voltage values (Vₒᵤₜ) shifting voltage levels of a digital signal (V_{din}) at said second power supply voltage (V_{supply}'), wherein
said power supply circuit (10) comprises
a comparison circuit (20) which compares said first high power supply voltage (V_{supply}) to a safe voltage threshold (V_{trig}), supplying a comparison signal (V_{comp}) to a circuit (13) of generation of a set of control voltages (VSHp, VSHn, shgnd) for said level shifter circuit (14),
said circuit (13) of generation of a set of control voltages (VSHp, VSHn, shgnd) supplies at its output said set of control voltages (VSHp, VSHn, shgnd), which takes a first set of values if said comparison signal (V_{comp}) indicates that said first high power supply voltage (V_{supply}) is below the safe voltage threshold (V_{trig}) and a second set of values if said comparison signal (V_{comp}) indicates that said first high supply voltage (V_{supply}) is above the safe voltage threshold (V_{trig}), the values of said first set of values being lower than the values of said second set of values.

## Description

### Technical field

The description relates to techniques for supplying power to a circuital arrangement, in particular NVM reading and writing circuits, using transistors, e.g. FETs or MOSFETs, operating at a lower voltage than said high voltage, for instance 3.3V with respect to 5.5V.

### Technological background

In circuits for controlling a high voltage value supplied to a circuital arrangement, in particular NVM reading and writing circuits, using transistors operating at a lower voltage than said high voltage, in particular where the high voltage evolution is asynchronous, e.g. with respect to clock signals of the circuital arrangement, is important the detection of the voltage value in order to manage in a safe operating area circuital arrangements such as non-volatile memory circuitry, i.e., to manage in safe mode the high voltage supply using medium voltage transistors, by way of example to use a high voltage supply, such as 5V using 3V voltage range transistors.

To supply an intermediate voltage (e.g., 3V) from a higher voltage (e.g., 5V), several circuit techniques can be used. These are common in applications such as non-volatile memories (NVMs) where read and write operations require different voltage levels.

In general, circuit such as Linear Voltage Regulators, e.g. Low Dropout Regulator (LDO) are used, or switching Voltage Regulators (DC-DC Converters), or also simpler Resistive Voltage Dividers

The use of MOSFET-Based Voltage Level Shifters, used for signal level shifting rather than power conversion may be particularly useful, for instance in connection with voltage supply of Non-Volatile memories (NVM). There, read operation might require, e.g., 3V logic, for power efficiency and compatibility with modern logic circuits, while write operations may use higher voltages (e.g., 5V or 12V) to program memory cells. Voltage level shifters allow compatibility between 3V transistors and higher voltage control logic.

In this context Level Shifters allow switching between different voltage domains, enabling seamless memory access.

A problem is thus to ensure a safe operating area while having an asynchronous rising and falling edge.

Another problem may be represented by the optimization of complexity of the embedded algorithm managing the control. Also a silicon area reduction in order to optimize System On Chip die size may present as a difficulty.

### Object and summary

An object of one or more embodiments is to contribute in dealing with a number of issues which are recognized to exist in a context as discussed in the foregoing.

According to one or more embodiments that object may be achieved by means of a power supply circuit having the features set forth in the claims that follow.

One or more embodiments may relate to a corresponding method for supplying power.

As mentioned previously, various embodiments of the present disclosure regard a power supply circuit configured to output, on the basis of a first high power supply voltage received at its input, power supply voltage values for transistors operating with a second power supply voltage lower than said first high power supply voltage, said power supply circuit comprising a level shifter circuit configured to supply said power supply voltage values shifting voltage levels of a digital signal at said second power supply voltage, wherein
said power supply circuit comprises
a comparison circuit which compares said first high-power supply voltage to a safe voltage threshold, supplying a comparison signal to a circuit of generation of a set of control voltages for said level shifter circuit,
said circuit of generation of a set of control voltages supplies at its output said set of control voltages, which takes a first set of values if said comparison signal indicates that said first high power supply voltage is below the safe voltage threshold and a second set of values if said comparison signal indicates that said first high supply voltage is above the safe voltage threshold, the values of said first set of values being lower than the values of said second set of values.

In variant embodiments, said set of control voltages comprises a pair of control voltages and said level shifter is a cascoded level shifter comprising a latch circuit and a driver circuit receiving said digital signal to be shifted, said driver circuit being coupled to said latch circuit through a first cascode subcircuit and a second cascode subcircuit, said pair of control voltages comprising a first control voltage coupled to the joint gates of the first cascode circuit and a respective second control voltage coupled to the joint gates of the second cascode circuit.

In variant embodiments, said latch comprises latched p MOSFET coupled to said first high power supply voltage, said driver circuit comprises n driver MOSFETs coupled to ground, and said first control voltage is ground, in particular zero volt, and said second control voltage takes a value lower than the half of said supply voltage and greater than zero, in particular 1.8 volt, if said first high supply voltage is below the safe voltage threshold, while said first and second voltage are the half of said supply voltage.

In variant embodiments, said comparison circuit comprises a divider circuit receiving at input said high voltage and which supplies at output a divided voltage to one input of a comparator, supplied by said second power supply, said comparator receiving at the other input a comparator reference voltage, said divider circuit being configured to supply said divided voltage with a value with respect to said comparator reference voltage so that said comparator changes its output when the high power supply voltage at input is above or below said safe threshold.

In variant embodiments, the circuit of generation of a set of control voltages comprises
a circuit configured to supply a reduced voltage obtained from said high voltage, in particular to halve the value of said high voltage,
a first circuit branch and a second branch coupled in parallel to the output of said comparator,
said first branch comprising a switching circuit which switches the first control voltage at the output of said first branch between said reduced voltage and ground depending on the comparison signal indicating that the high power supply voltage is above or below said safe threshold respectively,
said second branch comprising a switching circuit which switches the second control voltage at the output of said second branch 133, 134, 135) between said reduced voltage and a third voltage lower than reduced voltage and second voltage depending on the comparison signal indicating that the high power supply voltage is above or below the safe threshold respectively.

In variant embodiments, said set of control voltages comprises one control voltage which is supplied as ground reference of a not cascoded level shifter circuit, in particular a level shifter comprising a latch coupled to a driver circuit without interposition of cascode circuits, said not cascoded level shifter receiving said high power supply voltage as power supply voltage.

In variant embodiments, said comparison circuit includes a divider circuit with at least two selectable dividing ratios, in particular a resistive divider with three resistor in series, receiving at input said high voltage and which supplies at output a divided voltage to one input of a comparator, supplied by said second power supply, said comparator receiving at the other input a comparator reference voltage, said divider circuit being configured to supply said divided voltage with a value with respect to said comparator reference voltage so that said comparator changes its output value when the high power supply voltage at input is above or below said safe threshold, said comparison circuit comprising a feedback circuit coupled to the output of said comparator, comprising a switch triggered by the output value of the comparator, selecting one of the two selectable dividing ratios of the input high power supply voltage when the high power supply voltage at input is above or below said safe threshold, so that a hysteresis on the value at input of the comparator is introduced.

In variant embodiments, said transistors are comprised in a non-volatile memory and the second power supply voltage is used at least for the read operation.

In variant embodiments, the input high power supply voltage is 5 Volt and the second power supply voltage is 3V or 3.3V.

The solution here described in embodiments regards also a method for supplying power on the basis of a first high power supply voltage power voltage supply values for transistors operating with a second power supply voltage lower than said first high supply voltage, supplying said power voltage supply values shifting the voltage levels of a digital signal at said second power supply voltage
said method comprises
performing a comparison of said first high power supply voltage with respect to a safe voltage threshold,
generating a set of control voltages, in particular a pair of control voltages, which take a first set of values if said comparison indicates that said first high supply voltage is below the safe voltage threshold and a second set of values if said comparison indicates that said first high supply voltage is above the safe voltage threshold, the values of said first set of values being lower than the values of said second set of values.

In variant embodiments, said set of control voltages comprises a pair of control voltages and said shifting is obtained by a cascoded level shifter comprising a latch circuit and a driver circuit receiving said digital signal, said driver circuit being coupled to said latch circuit through a first cascode subcircuit and a second cascode subcircuit, supplying said pair of control voltages comprising a first control voltage coupled to the joint gates of the first cascode circuit and a respective second control voltage coupled to the joint gates of the second cascode circuit.

In variant embodiments, said comparing includes feeding back said comparison, performing a switch on the basis of said comparison, which enables a different dividing ratio of the input high power supply voltage, so that a hysteresis on the value at input of the comparator is introduced.

The claims are an integral part of the technical disclosure of the embodiments as provided herein.

### Brief description of the several views in the drawings

One or more embodiments will now be described, by way of example only, with reference to the annexed figures, wherein:
- Figures 1 shows a schematic circuit diagram of a power supply circuit according to the embodiments,
- Figure 2 shows a more detailed schematic circuit diagram of a power supply circuit according to the embodiments,
- Figure 3A and 3B show a circuit diagram of a level shifter module of the power supply circuit according to the embodiments in two operating states,
- Figure 4 is a time diagram showing of the signals power supply circuit according to the embodiments;
- Figure 5 is a schematic diagram of a further embodiment of a comparator of the power supply circuit here described;
- Figure 6A and 6B are diagrams represent further embodiments of the level shifter of figures 3A and 3B.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

Here, a circuit and method for controlling a high voltage value supplied to a circuital arrangement, in particular NVM reading and writing circuits, using transistors operating at a lower voltage than said high voltage. (e.g. 3.3V with respect to 5.5V), is described.

The power supply circuit comprises a comparator comparing said high voltage at input of said circuital arrangement to a safe threshold, the output of such comparator being coupled to a voltage generator circuit, which supplies a set of voltages to operate a level shifter to supply to the circuital arrangement the lower voltage if the high voltage value at input is over said threshold. In particular, a n voltage for the n cascode of a cascaded level shifter and a p voltage for the p cascode of a cascode level shifter are supplied.

Also, according to a relevant aspect of the solution here described, such control circuit may use a comparator receiving such high voltage input which includes a feedback circuit, with a switch triggered by the output value of the comparator, enabling a different dividing ratio of the input voltage, this introducing a hysteresis on the value at input of the comparator which present a vertical step of increase when the input voltage increasing crosses an up threshold and a vertical step of decrease when the input voltage decreasing crosses a down threshold.

It is underlined that such comparator with hysteresis may operate as a stand-alone, thus not in the circuit for controlling a high voltage value supplied to a circuital arrangement described above, in another circuit where detection of an input voltage with hysteresis is required.

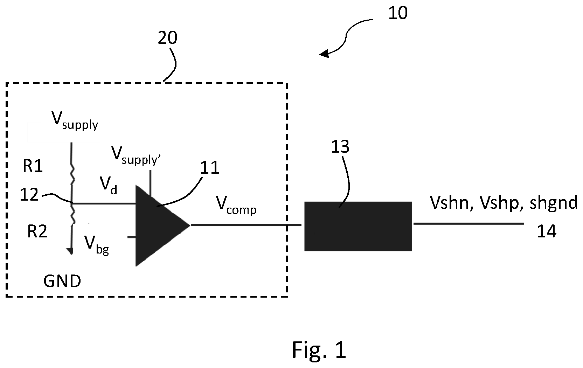

In figure 1 it is shown schematically a power supply circuit 10, i.e., a circuit to supply a voltage for power supply with a given value, according to the solution here described. An input high power supply voltage, V_{supply}, in the example 5 V, which corresponds to a high voltage supply, is sent to a comparison circuit 20, comprising a comparator 11 and a resistive divider 12. The resistive divider 12 receives at input said high power supply voltage, V_{supply} and comprises a first resistor R1 coupled to the input voltage V_{supply} and a second resistor R2 coupled to ground GND. A divided voltage V_{d} at the output, i.e, common node between resistor R1 and R2, of the divider 12 is brought at one input of the comparator 11 which at the other input receives a reference voltage V_{bg}, in particular obtained by a bandgap voltage reference circuit. A threshold voltage V_{trig} value for the comparator 11 is selected, by choosing the divider ratio in function of the reference voltage V_{bg}. In particular, the threshold voltage V_{trig} is equal to the reference voltage V_{bg} divided by the divider ratio. In the example, where V_{trig}=3.6V and V_{bg}=1.2 V, the resistor R1 is chosen with value two times R2, so that V_{d}= V_{supply}/3, i.e., for V_{supply}=3.6V equals V_{bg}. A comparator output V_{comp} of the comparator 11, which is power supplied at a lower voltage V_{supply}', in the example 3 V, is brought as input of a control voltage generator circuit 13, which is configured, on the basis of the comparator output V_{comp}, to generate a set of control voltages at its output, comprising a first control voltage Vshp, and a second control voltage Vshp. The second control voltage Vshp can be also used as shifted ground shgnd depending on the following circuit, in particular level shifter, which receives the set of control voltages from circuit 13. More in generale, such set of voltages comprises a first control voltage Vshp for devices operating with a first polarity, e.g. p MOSFETs, a second control voltage Vshp for devices operating with a second polarity opposite to the first, e.g. n mosfet, while the shifted ground shgnd is supplied as ground reference.

Thus the comparator 11 is configured to change its output state with respect to said threshold voltage V_{trig}, which is chosen with a value which can be sustained by devices, e.g. MOSFETs, operating with a second power supply lower that the first power supply V_{supply}, i.e. an intermediate power supply, V_{supply'}, which is for instance 3.3 or 3V with respect to the 5V of V_{supply} in the example here shown. The safe threshold voltage V_{trig} is by way of example 3.6 V.

The control voltage generator circuit 13 is a dedicated analog circuit which is configured to generate control voltages for a voltage level shifter 14.

As indicated, the control voltage generator circuit 13 has in general two voltage regions of operation:
V_{supply} < V_{trig} then a low value for the second control voltage Vshn, low value for the first voltage Vshp
V_{supply} > V_{trig} then high value for Vshn, high value for Vshp.

The high value for Vshn, Vshp is in general lower than V_{supply}, preferably V_{supply}/2. The low value may correspond to zero volt, i.e., the ground reference GND of the first high voltage supply, V_{supply}, but it can be also another voltage, in the example 1.8V, which is however lower than the high value for Vshn, Vshp, by at least a FET threshold voltage Vth (this for instance to take in account the lower threshold voltage of n FETs with respects to p FETS.

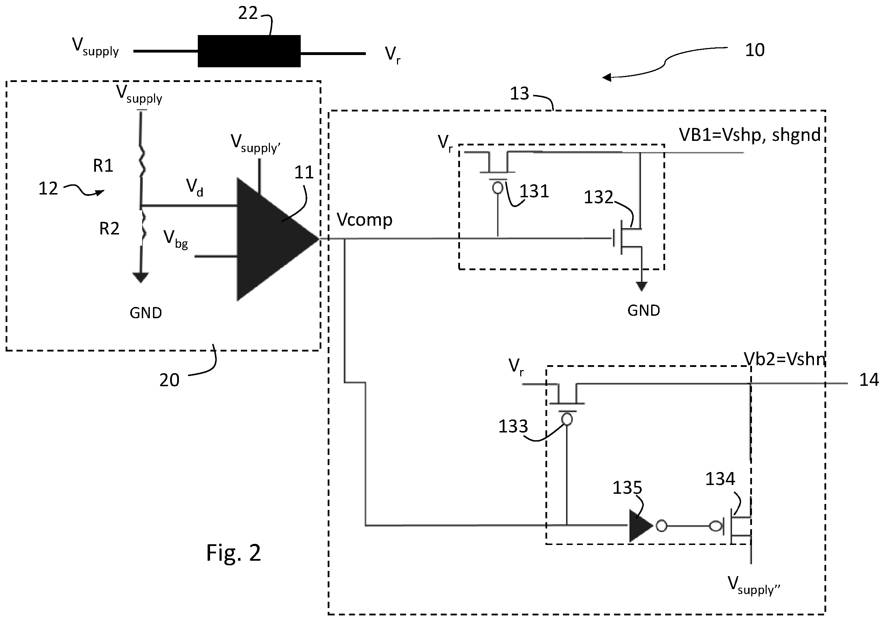

In figure 2 it is shown in more detail the circuit 10, detailing an embodiment of the shifted voltage generator circuit 13. The comparator 12 outputs the voltage V_{comp} to the shifted voltage generator 13, where it is supplied to two branches in parallel, each supplying a respective first branch output voltage VB1 and second branch output voltage VB2. Each of said two branches comprises a switch circuit, SW1, SW2. In figure 2 it is also shown a voltage divider circuit 22, which not necessarily is a resistive divider and which obtains a reduced voltage Vr from the input voltage, V_{supply}. In the example here described, Vr= V_{supply} /2. The first switch circuit SW1 switches between Vr and ground GND the first branch output voltage VB1, depending on the value of the output comparator V_{comp}, in particular in the example being respectively low or high. The second switch circuit SW2 switches between Vr and a third voltage supply V_{supply}‴, lower than V_{supply} and V_{supply}', in the example 1.8 V, depending on the value of the output comparator V_{comp}, in particular in the example being respectively low or high. More in detail, in the first switch SW1 the comparator output V_{comp} is supplied to the gates of two MOSFETs, a p MOSFET 131 which is coupled to the reduced voltage Vr at one electrode and to the drain of a n MOSFET 132, receiving comparator output V_{comp} on its gate as well as indicated. The source of the n MOSFET 132 is coupled to ground GND.

On the other branch the comparator output V_{comp} is brought to the gates of a p MOSFET 133 and p MOSFET 134, the latter through an inverter 135. P MOSFET 133 is coupled to the divided voltage V_{d} at one electrode and to the drain of p MOSFET 134 to the other. The other electrode of the p MOSFET 134 is coupled to the third voltage supply V_{supply}‴, lower than V_{supply} and V_{supply}', in the example 1.8 V.

Thus, when the output V_{comp} of the comparator 12 is low, e.g. OV, the MOSFET 131 is closed and MOSFET 132 open bringing the reduced voltage Vr as output VB1 of the first branch, which corresponds to Vshp and shgnd, in the example (V_{supply} /2). The MOSFET 133 is closed as well, and MOSFET 134 open, thus the output of the second branch, VB2, which corresponds to Vshn, is the reduced voltage Vr, which is for instance V_{supply} /2.

If the output V_{comp} of the comparator 12 is high, the MOSFET 131 is open, MOSFET 132 brings the output VB1, of the first branch to ground, e.g., 0 V, while the output of the second branch, VB2, with the MOSFET 133 open and the MOSFET 134 closed, corresponds to V_{supply"}.

Since in the example the divided voltage V_{d} is brought to the negative input of the comparator 12 and the reference voltage Vbg to the positive,

If V_{supply}<V_{trig} the output of the comparator 12 is high, e.g. 3 V, and VB1=0 (Vshp, shgnd=0), VB2=V_{supply}" (Vshn=1.8V).

If V_{supply}>V_{trig} the output of the comparator 12 is low, e.g. 0 V, and VB2=V_{d}=V_{supply}/2 (Vshp, shgnd=V_{d}), VB2= V_{d}=V_{supply}/2 (Vshn=V_{d}).

In general, the values of the second set of values, i.e., the values taken by VB1 and VB2, when V_{supply}>V_{trig}, with respect to the respective values in a first set of control values, i.e., the values taken by VB1 and VB2 when V_{supply}>V_{trig}, are chosen so that below and above the safe threshold V_{trig} there is a voltage above the conduction threshold on the transistors, e.g. threshold gate source voltage for the MOSFETs. Thus, VB1 for the p cascode is zero volt below the safe threshold and Vr above threshold, which means that at the transition, V_{supply}=3.6 volt, the voltage difference between the source of MOSFET 181a and gate of MOSFET 171a for instance is 3.6V (before V_{comp} changes value) and then reaches 2.5V (V_{supply} -Vᵣ=V_{supply}/2). For the n cascode, VB2 is V_{supply}"=1.8V below the safe threshold, and Vr above, which means that at the transition, V_{supply}=3.6 volt, the voltage difference between the source of MOSFET 151a and gate of MOSFET 161a for instance is 1.8V (before V_{comp} changes value) and then reaches 2.5V (Vᵣ-GND which is 0V). This on account of the polarity of the MOSFETs and the conduction threshold of n MOSFET being usually lower.

Thus, in general, above the safe threshold V_{trig} it is chosen the second set of values to have high values (preferably equal one to the other, in the example both V_{supply}/2, but differences between them are possible) which ensure conduction of the latch 18 and p cascode 17 transistors, in particular taking in account the voltage threshold value of the p MOSFETS which are higher, while the the first set of values is chosen to have low values (preferably different one with respect to the other) that ensure conduction of driver 15 and n cascode 16 transistors. By way of example, the value of 1.8 is chosen to have similar conduction values below the safe threshold V_{trig}.

Of course other arrangements of the two branches comprising switching circuit SW1 and SW2 are possible, changing the type of MOSFETs and also swapping the comparator 12 inputs between the divided voltage V_{d} and the reference voltage V_{bg}.

In general the comparator 12 supplies its comparator output V_{comp} to the generator circuit which supplies a set of voltages at its output comprising a first shifted voltage Vshp for devices operating with a first polarity, e.g. p MOSFETs, a second shifted voltage Vshp for devices operating with a second polarity opposite to the first, e.g. n MOSFETs. In embodiments, a shifted ground shgnd for the first and/or the second shifted voltage is taken on the same branch output, e.g. VB1, i.e. corresponds to the first shifted voltage Vshp.

If the voltage supply V_{supply} is below the threshold V_{trig}, the first shifted voltage Vshp for devices operating with a second polarity opposite to the first, e.g. p MOSFET, which in embodiments can correspond also to the shifted ground shgnd for the first and/or the second shifted voltage is has a low voltage value, e.g. OV, and the second shifted voltage Vshn has a respective low voltage value as well.

If the voltage supply V_{supply} is above the threshold V_{trig}, the first shifted voltage Vshp for devices operating with a second polarity opposite to the first, e.g. p MOSFET, which in embodiments can correspond also to the shifted ground shgnd for the first and/or the second shifted voltage has a high voltage value, e.g. Vr, and the second shifted voltage Vshn has a respective high voltage value, again Vr in the example, as well.

As indicated, the low voltage value for the first shifted voltage Vshp is not necessarily equal to the low voltage value for second shifted voltage Vshn, which in the example is higher, e.g., 1.8V, but they are both lower voltage value with respect to the high voltage value, i.e. Vr=V_{supply}/2.

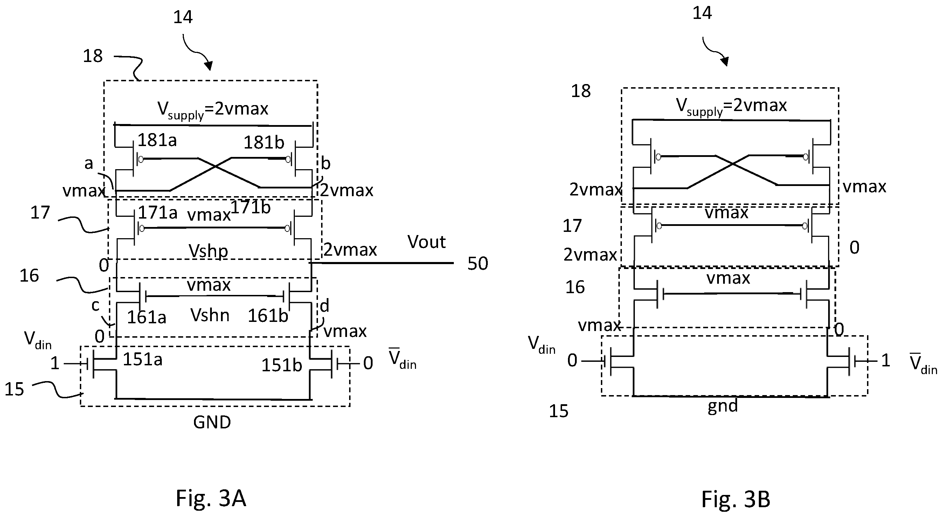

Then, figure 3A schematically illustrates a voltage level shifter 14, which represents the supplied circuitry 14 to which voltages of the set of voltages Vshp, Vshn at the outputs of circuit 13 are supplied, comprising PMOS driver switches 181a and 181b, forming a p driver circuit 18, each cascoded with a PMOS cascode switch 171a and 171b respectively, forming a p cascode circuit 17. The level shifter 14 further comprises NMOS driver switches 151a and 151b, forming a n driver circuit 15, each cascoded with an NMOS cascode switch 161a and 161b respectively, forming a n cascode circuit 16. The voltage level shifter 14 operates using a ground level, i.e, the ground GND, and two high level of voltage supply, namely the reduced voltage Vr, e.g. 2.5V, and the input high voltage V_{supply}, e.g. 5V. The reduced voltage Vr corresponds to a maximum voltage Vmax, which is set for the intermediate transistors, i.e. transistor, MOSFET in particular, which cannot use the standard supply between input high voltage supply at 5V and ground GND. Here cascode circuit means the circuit, e.g., 16 or 17, which associated with the respective driver, e.g., 15 or 18 forms a cascoded circuit arrangement.

PMOS driver switches 181a and 181b are cross coupled forming a latch 18, the gate of PMOS driver switch 105 being coupled to node b and the gate of PMOS driver switch 110 being coupled to node a. The PMOS driver switches 181a and 181b are coupled to the high voltage supply V_{supply}, i.e., 2*Vmax or 2*Vr.

PMOS cascode switches 171a and 171b have their respective gates connected together and tied to the first shifted voltage Vshp. Similarly NMOS cascode switches 161a and 161b have their respective gates connected together and tied to the second shifted voltage Vshn.

A control digital input signal V_{din} to the level shifter 14, i.e., the signal to be shifted by the level shifter 14, is coupled to the gate of NMOS driver switch 151a, whilst the negated control digital input signal V_{d}in signal is coupled to the gate of NMOS driver switch 151b.

All the MOSFETS of the level shifter 14, 151a, 151b, 161a, 161b, 171a, 171b, 181a, 181b, are intermediate voltage transistors, which operate with a voltage of 3V.

In the case of the control digital input signal V_{din} being logic high, i.e. at input of NMOS driver switch 151a on the right branch of the shifter 14, a high range output signal, corresponding to 2*Vmax, is generated at node b, whilst a low range output signal, corresponding to vmax, is generated at node a. At node c, on the right side, between 151a and 161a is generated 0 while at node d between 151b abd 161b on the left side is generated vmax. On a midpoint node out between the upper and lower halves of the level shifter 14, i.e., between cascode 16 and 17, on the left side, between 161b and 171b, is taken a level shifter output voltage Vₒᵤₜ, which corresponds to 2*Vmax, or V_{supply}, i.e., for the control digital input signal V_{d}in being logic high, the output Vₒᵤₜ is V_{supply}, despite the transistors of the level shifter only standing Vmax=V_{supply}/2.

The level shifter output voltage Vₒᵤₜ is then brought to a circuit arrangement 50, not shown in figure 3A, which uses the shifted voltage formed at output Vₒᵤₜ, e.g. a voltage between 0V and 3V, i.e. V_{supply'}, obtained from the high-power supply voltage 5V.

As mentioned the circuit 50 can be for instance a non volatile memory, which uses, at least for the read operation, MOSFETs power supplied at said second power supply voltage V_{supply'}.

It is underlined that the whole power supply circuit 10, which comprises the comparison circuit 20 and the generator of control voltages 13, not only the level shifter 14, uses transistors, in particular MOSFET, which operate with the lower power supply, i.e. they substantially are able to stand a potential difference of 3V or slightly higher, e.g. up to the safe threshold V_{trig}, in the example 3.6V, but not a potential difference of 5V, like the high power supply voltage V_{supply}.

In figure 3B it is shown that in the case of control digital input signal V_{d}in being logic high, the voltages between the left side and the right side are swapped.

If Vmax is the maximum voltage compatible with used devices and, to simplify, vth=0, vth being the threshold voltage of a MOSFET, with Vshn = Vmax and Vshp=Vmaz, thus the maximum voltage supply of the level shifter is 2*vmax, as shown in figure 3A, 3B

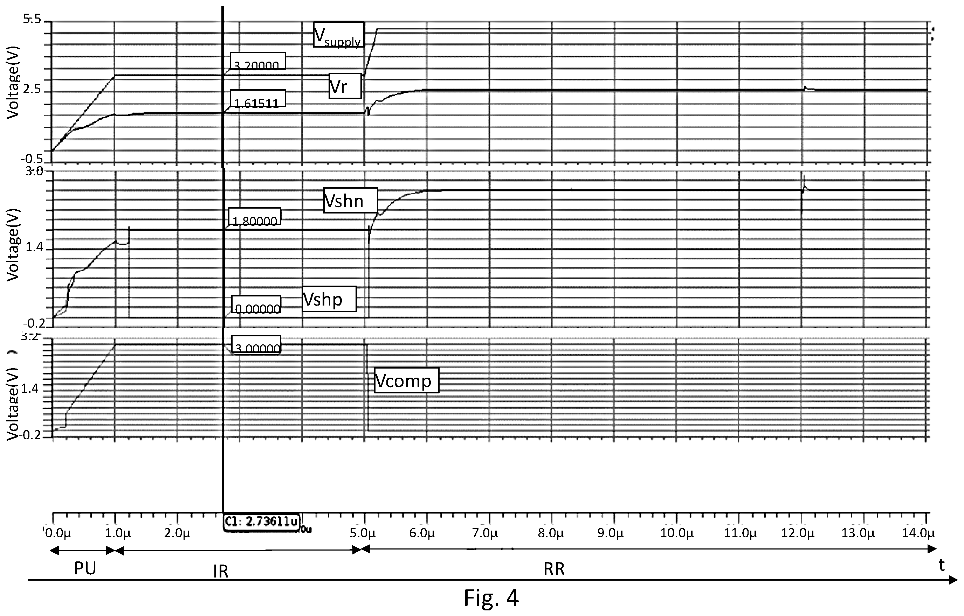

In figure 4 are shown the signals of the circuit of figures 2 and 3 as a function of time t, starting from power up conditions. A power up region is indicated with PU, approximately from 0 to 1 ms. With V_{supply} is indicated the high voltage supply and the reduced voltage Vᵣ is also shown. As show, the high voltage supply V_{supply} in this example increases from 0 to a level of 3.2 V, accordingly the reduced voltage Vᵣ has half its value, reaching circa 1.6V. In the power up region PU the comparator output V_{comp} increases till to reaching its high value, 3V, since the high voltage supply V_{supply} is at maximum 3.2V below the threshold V_{trig} value, 3.6 V. In an intermediate region IR V_{supply} stays below Vtrg, thus Vshn is at V_{supply}'', 1.8V and Vshp is 0V. Then, when in a high voltage region RR the high voltage supply V_{supply} reaches its maximum value of 5V, above the threshold V_{trig} value, 3.6 V, the reduced voltage Vr consequently goes to V_{supply}/2, 2.5 V, the comparator 12 toggles its comparator output V_{comp} which goes from high, 3 V, to low, 0V. At this point, as a consequence both Vshn and Vshp (and shgnd) go to Vr=V_{supply}/2.

In variant embodiments, the level shifter can be also not cascoded, e.g., include only the latch and the input driver. In that case the shifted p voltage Vshp is supplied as shifted ground shgnd and the high voltage supply V_{supply} is supplied as power supply of the level shifter.

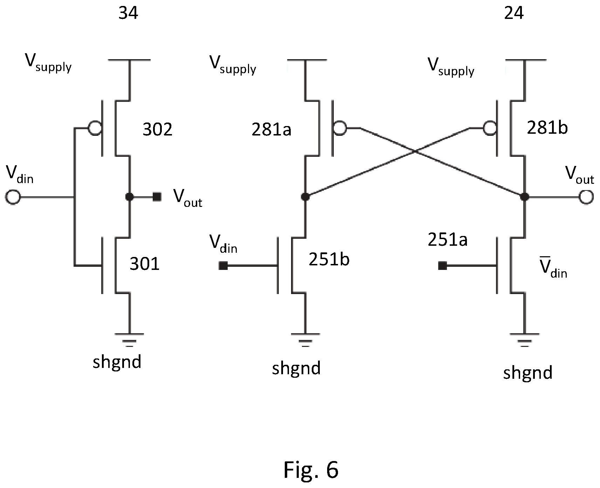

As shown in figure 6A, a latch with MOSFETs 281a, 281b is coupled to the high voltage supply V_{supply}, while the input driver is formed by MOSFETs 251a, 251b and coupled to the shifted ground shgnd.

When V_{supply}< V_{trig}, i.e., below 3.6V in the example, the ground correspond to shgnd, i.e. is OV, thus across the MOSFETs there is a voltage which is 3.6 at amaximu. When V_{supply}>V_{triq} then shgnd is V_{supply}/2 and thus the difference of voltage on the MOSFETs is V_{supply}-V_{supply}/2, 2.5V at maximum.

In figure 6B is also shown simpler level shifter 34, with a p MOSFET 301 and a n MOSFET 302 coupled in series between the power supply V_{supply} and the ground shgnd, receiving the input digital voltage V_{din}.

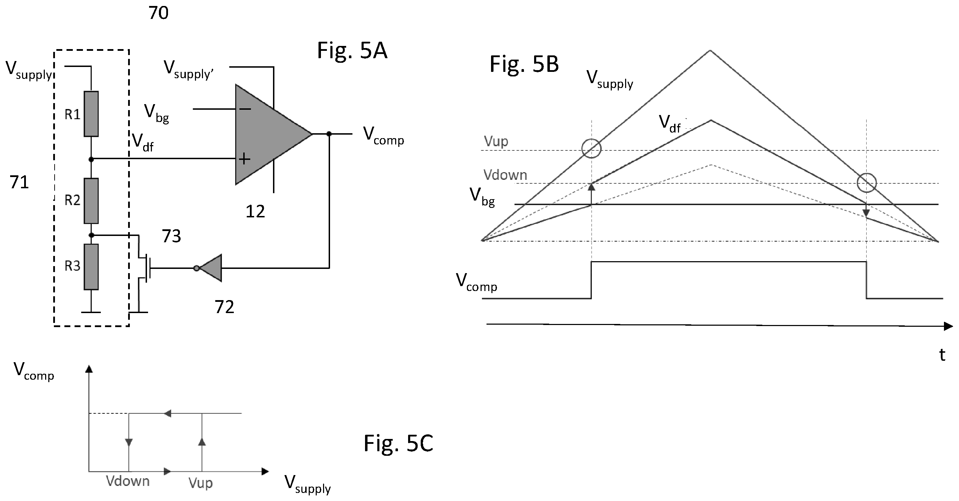

With reference to the figure 5, it is shown an embodiment of the portion comprising the comparator 12, which, to avoid spurious transitions of the comparator 12 due to possible undershoots, includes a hysteresis

Thus, in figure 5A the comparator 12 is coupled to a resistive divider 71 receiving the high voltage supply V_{supply}, comprising three resistors in series R1, R2, R3. A divided feedback voltage V_{d}f is taken on the node between resistor R1 and R2 and brought as input (positive input in this case) of the comparator 12 which receives at the other input (negative) the reference voltage Vbg. The output V_{comp} of the comparator 12 is brought back to an inverter 72 which output drives a n MOSFET MN1 which drain is coupled to the node between resistor R2 and R3.

Thus, the high voltage supply V_{supply}, may be divided by two different ratios, depending on the value at the comparator output V_{comp} of the comparator 12, as a high value of the comparator output V_{comp} switches on the n MOSFET MN1, making the divider ratio R2/R1+R2, while a low value of the comparator output V_{comp} switches off the MOSFET MN1, making the divider ratio (R2+R3)/R1+R2+R3.

The divided feedback voltage V_{df} is consequently: ${V}_{df} = {V}_{supply} * \left(R2/R1+R2\right) with 73 on ,$ and ${V}_{df} = {V}_{supply} * \left(R2+R3\right) / \left(R1+R2+R3\right) with 73 off$ i.e. the divided feedback voltage V_{df} is higher with transistor 73 on. As shown in figure 5B, which shows the signals as function of time, V_{supply}, Vbg, Vup, V_{d}own, V_{d}f and V_{comp}, the input voltage V_{supply} and the divided feedback voltage V_{df} increase. When the feedback voltage V_{df} surpasses the reference voltage V_{bg}, the output V_{comp} of the comparator 70 goes high, switching off transistor 73, changing the divider ratio, i.e. shifting up the value of the divided feedback voltage V_{df}. This corresponds to the up threshold value Vup for the input high voltage supply V_{supply}, shown in figure 5C, which is a diagram showing the comparator output V_{comp} versus the input high voltage supply V_{supply}. When the up threshold value Vup is passed by the increasing supply input voltage Vin. When the input voltage Vin decreases and goes below reference voltage VREF, the comparator output V_{comp} goes low and the divided voltage feedback V_{d}f is shifted down. This corresponds to a low threshold value V_{d}own, lower than the up threshold value Vup, of the input high voltage supply V_{supply}. Thus the input high voltage supply V_{supply} increasing triggers the comparator 12 at a higher threshold, the up threshold value Vup, while decreasing triggers the comparator 12 at a lower threshold, the low threshold value V_{d}own, thus operating with a hysteresis.

This ensures a safe operating area while having an asynchronous rising and falling edge.

Thus, on the basis of the above description, the solution here described refers to a power supply circuit, e.g., 10, configured to output, on the basis of a first high power supply voltage, e.g., V_{supply}, in the example 5V, received at its input, power supply voltage values, e.g., the output signal Vₒᵤₜ of the level shifter 14, for transistors, e.g., 50, which may be for instance the MOSFETs of a NVM, in particular to perform a cell read operation, operating with a second power supply voltage, e.g., V_{supply}', which is in the 3V range in the example, e.g. 3V or 3.3V, lower than said first high power supply voltage, e.g., V_{supply}, such power supply circuit, e.g., 10, comprising a level shifter circuit,, e.g. the cascoded circuit 14, although it may be also a not cascoded version, e.g., 24 or 34, configured to supply said power supply voltage values, e.g., Vₒᵤₜ, shifting voltage levels of a digital signal, e.g., V_{din}, at said second power supply voltage, e.g., V_{supply}', wherein
said power supply circuit, e.g., 10, comprises
a comparison circuit, e.g., 20 or also 70, which compares said first high power supply voltage, e.g., V_{supply}, to a safe voltage threshold, e.g., V_{trig}, supplying a comparison signal, e.g., the output V_{comp}, to a circuit, e.g., 13, of generation of a set of control voltages, e.g., VSHp, VSHn, shgnd also indicated as VB1 and VB2 as branch outputs, for said level shifter circuit, e.g., 14,
said circuit, e.g., 13, of generation of a set of control voltages, e.g., VSHp, VSHn, shgnd, supplies at its output said set of control voltages, VSHp, VSHn, shgnd, which takes a first set of values, e.g., 0V and 1.8V, if said comparison signal, e.g.,V_{comp}, indicates that said first high power supply voltage, e.g., V_{supply}, e.g., is below the safe voltage threshold, e.g., V_{trig}, and a second set of values if said comparison signal, V_{comp}, indicates that said first high supply voltage, e.g., V_{supply}, is above the safe voltage threshold, V_{trig}, the values of said first set of values being lower than the values of said second set of values.

As indicated, the first set of values and second set of values are chosen so as to ensure that the transistors of the level shifter, in particular p MOSFETs and n MOSFETs are in conduction both when the first high power supply voltage, e.g., V_{supply}, e.g., is below the safe voltage threshold, e.g., V_{trig}, and is above the safe voltage threshold, e.g., V_{trig}. Thus, in general are chosen values for first set of values and second set of values which at least ensure over the relevant transistor or the transistors of the level shifter a voltage drop which is above the voltage threshold, e.g., the gate source voltage of the MOSFET. Clearly, the first set of values, i.e. higher voltages, is limited to the maximum operation value of the intermediate transistors, choosing a reduced voltage Vr which is at least lower than the safe threshold. It is observed that also a dual level shifter, with a n latch coupled to ground and a p driver coupled to the first high power supply voltage, e.g., V_{supply} still operates with the same control voltages, e.g., VSHp, VSHn, thus, also in this case holds that the values of such first set of values are lower than the values of said second set of values.

In an embodiment, the set of control voltages is a pair of control voltages, e.g., VSHp, VSHn, and said level shifter, e.g., 14, is a cascoded level shifter comprising a latch circuit, e.g., 18, and a driver circuit, e.g., 15, receiving said digital signal, e.g., V_{din}, to be shifted, said driver circuit, e.g., 15, being coupled to said latch circuit, e.g., 19, through a first cascode subcircuit, e.g., n cascode 16, and a second cascode subcircuit, e.g., p cascode 17, i.e., the latch 18 and the driver 15 are cascoded, said pair of control voltages comprising a first control voltage, Vshn, coupled to the joint gates of the first cascode subcircuit, e.g., 16, which is formed by two n MOSFETS 161a, 161b, and a respective second control voltage, Vshp, coupled to the joint gates of the second cascode circuit, e.g., 17 which is formed by two p MOSFETS 171a, 171b. In particular, the latch, e.g., 18, comprises latched p MOSFET, e.g., 181a, 181b, coupled to said first high power supply voltage, e.g., V_{supply}, said driver circuit, e.g., 15, comprises n driver MOSFETs, e.g., 151a, 151b, coupled to ground, i.e., the ground GND of the high voltage Vsupply, zero volt, and said first control voltage is ground, in particular zero volt, and said second control voltage takes a value lower than the half, e.g. reduced voltage Vᵣ, of said supply voltage, e.g., Vsupply, and greater than zero, in particular 1.8 volt, if said first high supply voltage, e.g., V_{supply}, is below the safe voltage threshold, e.g., V_{trig}, while said first, e.g., Vshp, and second control voltage, e.g., Vshn, are the half, e.g., Vᵣ, of said supply voltage, e.g., V_{supply}.

The power supply circuit here described comprises then a comparison circuit, e.g., 20, but also 70, which, comprises a divider circuit, e.g., 12, receiving at input said high voltage, e.g., V_{supply}, and which supplies at output a divided voltage, e.g., V_{d}, to one input, as shown it may the negative as in figure 2 or positive as in figure 5, of a comparator, e.g., 11, supplied by said second power supply, e.g., V_{supply"}, said comparator, e.g., 11, receiving at the other input a comparator reference voltage,, e.g., V_{bg} from a bandgap voltage reference circuit although it may a different type of voltage reference, said divider circuit, e.g., 12, being configured to supply said divided voltage, e.g., V_{d}, with a value with respect to said comparator reference voltage, V_{bg}, so that said comparator, 11, changes its output when the high power supply voltage, V_{supply}, at input is above or below said safe threshold, V_{trig},.

The circuit, e.g., 13, of generation of a set of control voltages, e.g., VSHp, VSHn, shgnd, comprises
a circuit, e.g., 22, which is for instance a divider, not necessarily a resistive divider, configured to supply a reduced voltage, e.g., Vᵣ, obtained from said high voltage, e.g., V_{supply},, in particular to halve the value of said high voltage, e.g., V_{supply},
a first circuit branch, e.g., 131, 132, and a second branch, e.g., 133, 134, 135, coupled in parallel to the output of said comparator, e.g., 12,
said first branch, e.g., 131, 132, comprising a switching circuit, e.g., switches 131, 132 embodies by MOSFETs, although of course other switch network also with other type of switching devices are possible to obtain the same set of control voltages on the branches of circuit 13 depending on the comparator output, which switches the first control voltage at the output of said first branch between said reduced voltage, e.g., Vᵣ, and ground, e.g., GND, depending on the comparison signal, e.g., V_{comp}, indicating that the high power supply voltage, e.g., V_{supply}, is above or below said safe threshold, e.g., V_{trig}, respectively,
said second branch comprising a switching circuit, e.g., 133, 134, 135, which switches the second control voltage at the output of said second branch, e.g., 133, 134, 135, between said reduced voltage, e.g., Vr, and a third voltage, e.g., V_{supply}", lower than the reduced voltage, e.g., Vr, and second, e.g., V_{supply}', voltage depending on the comparison signal, e.g., V_{comp}, indicating that the high power supply voltage, e.g., V_{supply}, is above or below the safe threshold, e.g., V_{trig}, respectively.

The set of control voltages, e.g., shgnd, comprises one control voltage,, e.g., shgnd, which is supplied as ground reference of a not cascoded level shifter circuit, in particular a level shifter comprising a latch, e.g., 281a, 282b, coupled to a driver circuit, e.g., 251a, 251b, without interposition of cascode circuits, said not cascoded level shifter receiving said high power supply voltage, e.g., V_{supply}, as power supply voltage. Thus, the circuit 13 may indeed supply still a pair of voltages, Vshp, Vshn, at the end of its two branches, but only Vshp is taken in this case to operate as shifted ground for the level shifter without cascading, which is then coupled at the power supply node to the high voltage V_{supply}.

It is also here described a comparison circuit, e.g., 70, which can be used in place of comparison circuit 20, which includes a divider circuit, e.g., 71, with at least two selectable dividing ratios, in particular a resistive divider with three resistor, e.g. R1, R2, R3 in series, receiving at input said high voltage, e.g., V_{supply}, and which supplies at output a divided voltage, e.g., V_{df}, to one input of a comparator, e.g., 12,, supplied by said second power supply, e.g., V_{supply"}, said comparator, e.g., 11, receiving at the other input a comparator reference voltage, e.g., V_{bg}, said divider circuit, e.g., 71, being configured to supply said divided voltage, e.g., V_{df}, with a value with respect to said comparator reference voltage, e.g., V_{bg}, so that said comparator, e.g., 11, changes its output value, e.g., V_{comp}, when the high power supply voltage, e.g., V_{supply}, at input is above or below said safe threshold, e.g., V_{trig},, said comparison circuit, e.g., 20, comprising a feedback circuit, e.g., 72, 73, coupled to the output of said comparator, e.g., 11,, comprising a switch, e.g., 73, triggered by the output value, e.g., V_{comp}, of the comparator, e.g., 11,, selecting one of the two selectable dividing ratios of the input high power supply voltage, e.g., V_{supply}, when the high power supply voltage, e.g., V_{supply}, at input is above or below said safe threshold, e.g., V_{trig},, so that a hysteresis on the value at input of the comparator, e.g., 11, is introduced. The switch 73 in particular allows to couple the comparator 11 either to the node between R2 and R3, the latter being coupled to ground GND, or the divided input, R1, and R2.

It is underlined here that the comparison circuit 70 can employed as a hysteresis comparator also outside the power supply circuit 10 here described. Thus it here described also a stand-alone comparison circuit which includes a divider circuit, e.g., 71, with at least two selectable dividing ratios, in particular a resistive divider with three resistor, e.g. R1, R2, R3 in series, receiving at input a high voltage, e.g., V_{supply}, and which supplies at output a divided voltage, e.g., V_{df}, to one input of a comparator, e.g., 12, supplied by a second power supply, e.g., V_{supply"}, said comparator, e.g., 11, receiving at the other input a comparator reference voltage, e.g., V_{bg}, said divider circuit, e.g., 71, being configured to supply said divided voltage, e.g., V_{df}, with a value with respect to said comparator reference voltage, e.g., V_{bg}, so that said comparator, e.g., 11, changes its output value, e.g., V_{comp}, when the high power supply voltage, e.g., V_{supply}, at input is above or below said safe threshold, e.g., V_{trig},, said comparison circuit, e.g., 70, comprising a feedback circuit, e.g., 72, 73, coupled to the output of said comparator, e.g., 11,, comprising a switch, e.g., 73, triggered by the output value, e.g., V_{comp}, of the comparator, e.g., 11,, selecting one of the two selectable dividing ratios of the input high power supply voltage, e.g., V_{supply}, when the high power supply voltage, e.g., V_{supply}, at input is above or below said safe threshold, e.g., V_{trig},, so that a hysteresis on the value at input of the comparator, e.g., 11, is introduced. The switch 73 in particular allows to couple the comparator 11 either to the node between R2 and R3, the latter being coupled to ground GND, or the divided input, R1, and R2. Such a stand-alone comparison circuit, e.g., 70, may be used with or integrated in any other circuit requiring a comparison with hysteresis of an input voltage.

The transistors, e.g., of a circuit 50, may be comprised in a non-volatile memory and the second power supply voltage, e.g., V_{supply'}, may be used at least for the read operation.

The input high power supply voltage, e.g., V_{supply}, is by way of example 5 Volt and the second power supply voltage, e.g., V_{supply'}, is 3V or in the 3V range.

From the description here above thus the advantages of the solution described are clear.

Advantageously, the solution described allows to manage high voltages without dedicated devices, i.e., with devices, in particular MOSFETs, which operate with lower voltages. This obtained in particular by a comparator which controls a generator of the voltages for the level shifter.

Advantageously, the whole power supply circuit uses transistors, in particular MOSFET, which operate with lower voltages.

The adoption a comparator with hysteresis ensures a safe operating area while having an asynchronous rising and falling edge
Without prejudice to the underlying principles, the details and embodiments may vary, even significantly, with respect to what has been described by way of example only, without departing from the extent of protection.

The extent of protection is defined by the annexed claims.

## Claims

1. A power supply circuit (10) configured to output, on the basis of a first high power supply voltage (V_{supply}) received at its input, power supply voltage values (Vₒᵤₜ) for transistors (50) operating with a second power supply voltage (V_{supply}') lower than said first high power supply voltage (V_{supply}), said power supply circuit (10) comprising a level shifter circuit (14; 24; 34) configured to supply said power supply voltage values (Vₒᵤₜ) shifting voltage levels of a digital signal (V_{din}) at said second power supply voltage (V_{supply}'), wherein
said power supply circuit (10) comprises
a comparison circuit (20) which compares said first high power supply voltage (V_{supply}) to a safe voltage threshold (V_{trig}), supplying a comparison signal (V_{comp}) to a circuit (13) of generation of a set of control voltages (VSHp, VSHn, shgnd) for said level shifter circuit (14),
said circuit (13) of generation of a set of control voltages (VSHp, VSHn, shgnd) supplies at its output said set of control voltages (VSHp, VSHn, shgnd), which takes a first set of values if said comparison signal (V_{comp}) indicates that said first high power supply voltage (V_{supply}) is below the safe voltage threshold (V_{trig}) and a second set of values if said comparison signal (V_{comp}) indicates that said first high supply voltage (V_{supply}) is above the safe voltage threshold (V_{trig}), the values of said first set of values being lower than the values of said second set of values.

2. The circuit of claim 1 or 2, wherein said set of control voltages (VSHp, VSHn, shgnd) comprises a pair of control voltages (VSHp, VSHn) and said level shifter (14) is a cascoded level shifter comprising a latch circuit (18) and a driver circuit (15) receiving said digital signal (V_{din}) to be shifted, said driver circuit (15) being coupled to said latch circuit (18) through a first cascode subcircuit (16) and a second cascode subcircuit (17), said pair of control voltages (VSHp, VSHn, shgnd) comprising a first control voltage (Vshn) coupled to the joint gates of the first cascode subcircuit and a respective second control voltage (Vshp) coupled to the joint gates of the second cascode subcircuit (17).

3. The circuit of claim 2, wherein said latch (18) comprises latched p MOSFET (181a, 181b) coupled to said first high power supply voltage (V_{supply}), said driver circuit (15) comprises n driver MOSFETs (151a, 151b) coupled to ground, and said first control voltage is ground, in particular zero volt, and said second control voltage takes a value lower than the half (Vᵣ) of said supply voltage (Vsupply) and greater than zero, in particular 1.8 volt, if said first high supply voltage (V_{supply}) is below the safe voltage threshold (V_{trig}), while said first (Vshp) and second voltage (Vshn) are the half (Vᵣ) of said supply voltage (Vsupply).

4. The circuit of any of the previous claims, wherein said comparison circuit (20) comprises a divider circuit (12) receiving at input said high voltage (V_{supply}) and which supplies at output a divided voltage (V_{d}) to one input of a comparator (11), supplied by said second power supply (V_{supply"}), said comparator (11) receiving at the other input a comparator reference voltage (V_{bg}), said divider circuit (12) being configured to supply said divided voltage (V_{d}) with a value with respect to said comparator reference voltage (V_{bg}) so that said comparator (11) changes its output when the high power supply voltage (V_{supply}) at input is above or below said safe threshold (V_{trig}).

5. The circuit of any of the previous claims, wherein the circuit (13) of generation of a set of control voltages (VSHp, VSHn, shgnd) comprises
a circuit (22) configured to supply a reduced voltage (Vᵣ) obtained from said high voltage (V_{supply}), in particular to halve the value of said high voltage (V_{supply}) ,
a first circuit branch (131, 132) and a second branch (133, 134, 135) coupled in parallel to the output of said comparator (12),
said first branch (131, 132) comprising a switching circuit (131, 132) which switches the first control voltage at the output of said first branch between said reduced voltage (Vᵣ) and ground (GND) depending on the comparison signal (V_{comp}) indicating that the high power supply voltage (V_{supply}) is above or below said safe threshold (V_{trig}) respectively,
said second branch comprising a switching circuit (133, 134, 135) which switches the second control voltage at the output of said second branch 133, 134, 135) between said reduced voltage (Vr) and a third voltage (V_{supply}") lower than reduced voltage (Vr) and second (V_{supply}') voltage depending on the comparison signal (V_{comp}) indicating that the high power supply voltage (V_{supply}) is above or below the safe threshold (V_{trig}) respectively.

6. The circuit of claim 1, wherein said set of control voltages (VSHp, VSHn, shgnd) comprises one control voltage which is supplied as ground reference of a not cascoded level shifter circuit, in particular a level shifter comprising a latch (281a, 282b) coupled to a driver circuit (251a, 251b) without interposition of cascode circuits, said not cascoded level shifter receiving said high power supply voltage (V_{supply}) as power supply voltage.

7. The circuit of any of the previous claims, wherein said comparison circuit (20) includes a divider circuit (71) with at least two selectable dividing ratios, in particular a resistive divider with three resistor in series, receiving at input said high voltage (V_{supply}) and which supplies at output a divided voltage (V_{df}) to one input of a comparator (12), supplied by said second power supply (V_{supply"}), said comparator (11) receiving at the other input a comparator reference voltage (V_{bg}), said divider circuit (12) being configured to supply said divided voltage (V_{df}) with a value with respect to said comparator reference voltage (V_{bg}) so that said comparator (11) changes its output value (V_{comp}) when the high power supply voltage (V_{supply}) at input is above or below said safe threshold (V_{trig}), said comparison circuit (20) comprising a feedback circuit (72, 73) coupled to the output of said comparator (11), comprising a switch (73) triggered by the output value (V_{comp}) of the comparator (11), selecting one of the two selectable dividing ratios of the input high power supply voltage (V_{supply}) when the high power supply voltage (V_{supply}) at input is above or below said safe threshold (V_{trig}), so that a hysteresis on the value at input of the comparator (11) is introduced.

8. The circuit of any of the previous claims, wherein said transistors (50) are comprised in a non-volatile memory and the second power supply voltage (V_{supply'}) is used at least for the read operation.

9. The circuit of any of the previous claims, wherein the input high power supply voltage (V_{supply}) is 5 Volt and the second power supply voltage (V_{supply'}) is in the range of 3V, in particular 3V or 3.3V.

10. A method for supplying power on the basis of a first high power supply voltage (V_{supply}) power voltage supply values (Vₒᵤₜ) for transistors (50) operating with a second power supply voltage (V_{supply}') lower than said first high supply voltage (V_{supply}), supplying said power voltage supply values (Vₒᵤₜ) shifting (14; 24; 34) the voltage levels of a digital signal (V_{din}) at said second power supply voltage (V_{supply}')
said method comprises
performing a comparison (20) of said first high power supply voltage (V_{supply}) with respect to a safe voltage threshold (V_{trig}),
generating (13) a set of control voltages (VSHp, VSHn, shgnd), in particular a pair of control voltages, which take a first set of values if said comparison (20) indicates that said first high supply voltage (V_{supply}) is below the safe voltage threshold (V_{trig}) and a second set of values if said comparison (20) indicates that said first high supply voltage (V_{supply}) is above the safe voltage threshold (V_{trig}), the values of said first set of values being lower than the values of said second set of values.

11. The method of claim 10, wherein said set of control voltages (VSHp, VSHn, shgnd) comprises a pair of control voltages (VSHp, VSHn) and said shifting (14) is obtained by a cascoded level shifter comprising a latch circuit (18) and a driver circuit (15) receiving said digital signal (V_{din}), said driver circuit (15) being coupled to said latch circuit (19) through a first cascode subcircuit (16) and a second cascode subcircuit (17), supplying said pair of control voltages (VSHp, VSHn, shgnd) comprising a first control voltage (Vshn) coupled to the joint gates of the first cascoded circuit and a respective second control voltage (Vshp) coupled to the joint gates of the second cascode subcircuit (17).

12. The method of claim 10 or 11, wherein said comparing includes feeding back said comparison, performing a switch (73) on the basis of said comparison (20), which enables a different dividing ratio of the input high power supply voltage (V_{supply}), so that a hysteresis on the value at input of the comparator (11) is introduced.
